# EUROPEAN PATENT APPLICATION

(11) **EP 4 394 860 A1**
(43) Date of publication of application: **03.07.2024**
(21) Application number: 23201007.4
(22) Date of filing: 29.09.2023
(51) Int. Cl.: H01L 23/15, H01L 23/498

(54) **ARCHITECTURES AND METHODS FOR METAL LAMINATION ON A GLASS LAYER**

(30) Priority: 28.12.2022 US 202218147457
(71) Applicant: INTEL Corporation, Santa Clara, CA 95054 (US)
(72) Inventor: MARIN, Brandon, AZ, 85234 (US); KANDANUR, Sashi, AZ, 85226 (US); PIETAMBARAM, Srinivas, AZ, 85249 (US); DUAN, Gang, AZ, 85248 (US); ECTON, Jeremy, AZ, 85298 (US)
(74) Representative: HGF

(57) **Abstract**

Architectures and methods for metal lamination on a glass layer or glass core. The architectures implement dummy anchors to prevent or reduce the delamination of conductive materials from glass surfaces. The anchors hold the conductive pads and conductive material planes down to the glass surface. The architecture includes various combinations of end anchors and through glass via (TGV) anchors.

## Description

### BACKGROUND

For a variety of reasons, glass is expected to improve the mechanical and electrical performance of semiconductor substrate packages over other core materials. However, implementing a glass layer can introduce a variety of technical challenges and reliability issues. Accordingly, improved methods and architectures that can be used with substrates having glass cores and glass layers are desired.

### BRIEF DESCRIPTION OF THE DRAWINGS

FIG. 1A is a simplified top-down view of a glass layer showing a through glass via (TGV) pattern indicated on its surface.
FIG. 1B illustrates the view of FIG. 1A, with a conductive material overlaid on its upper surface.
FIG. 2A illustrates the view of FIG. 1A showing the TGV pattern modified to add edge anchors and add TGV anchors, in accordance with various embodiments.
FIG. 2B is a simplified enlargement of a portion of the glass layer of FIG. 2A, showing placement of the TGV anchors around one TGV, in accordance with various embodiments.
FIG. 3A illustrates the view of FIG. 2A, having a conductive material overlaid on its upper surface, as part of a manufacturing process, in accordance with various embodiments.
FIG. 3B illustrates the view of FIG. 2B, having a conductive material overlaid on its upper surface, as part of a manufacturing process, in accordance with various embodiments.
FIG. 4A illustrates the view of FIG. 3A after the conductive material has been etched away to reveal only filled TGVs and filled anchors, for discussion purposes.
FIG. 4B illustrates the view of FIG. 3B after the conductive material has been etched away to form a conductive routing layer attached to and overlaying the TGV, in accordance with various embodiments.
FIG. 5 provides a simplified cross-sectional view of a portion of a glass layer with TGVs, conductive routing on an upper surface and a lower surface, and architectural enhancements for metal lamination, in accordance with various embodiments.
FIG. 6 depicts the architectural enhancements for metal lamination in a context of a package substrate, in accordance with various embodiments.
FIG. 7 illustrates an example method for manufacturing architectural enhancements for metal lamination, in accordance with various embodiments.
FIG. 8 is a top view of a wafer and dies that may be included in a microelectronic assembly, in accordance with any of the embodiments disclosed herein.
FIG. 9 s a simplified cross-sectional side view showing an implementation of an integrated circuit on a die that may be included in various embodiments, in accordance with any of the embodiments disclosed herein.
FIG. 10 is a cross-sectional side view of a microelectronic assembly that may include any of the embodiments disclosed herein.
FIG. 11 is a block diagram of an example electrical device that may include any of the embodiments disclosed herein.

### DETAILED DESCRIPTION

The rigidity of glass and its ability to provide a planar surface is expected to impart mechanical and electrical improvements to a substrate package over other core materials. However, some desirable architectures are technically challenging to implement with glass. For example, when metal pads or routing are located directly on the glass surface, stress between the glass and metal (e.g., copper) can lead to delamination of the metal layer or cracking of the glass layer.

Embodiments described herein provide a technical solution to these technical challenges in the form of architectures and methods for metal lamination on a glass layer/glass core. The provided architectures and methods can be used in semiconductor packaging processes and devices. Embodiments implement dummy anchors (end anchors and through glass via (TGV) anchors) that prevent or reduce the delamination of the copper from glass surfaces. The anchors hold the conductive pads and conductive material planes down to the glass surface and thereby prevent/reduce delamination. Experiments have produced results in which delamination gets arrested when compared to apparatus and methods that do not implement the provided architectures. Embodiments decrease cost and increase reliability of processes and devices.

Example embodiments are hereinafter be described in conjunction with the following drawing figures, wherein like numerals denote like elements. Figures are not necessarily to scale but may be relied on for spatial orientation and relative positioning of features. As may be appreciated, certain terminology, such as "ceiling" and "floor", as well as "upper,", "uppermost", "lower," "above," "below," "bottom," and "top" refer to directions based on viewing the Figures to which reference is made. Further, terms such as "front," "back," "rear,", "side", "vertical", and "horizontal" may describe the orientation and/or location of portions of the component within a consistent but arbitrary frame of reference which is made clear by reference to the text and the associated Figures describing the component under discussion. Such terminology may include the words specifically mentioned above, derivatives thereof, and words of similar import.

As used herein, the term "adjacent" refers to layers or components that are in direct physical contact with each other, with no layers or components in between them. For example, a layer X that is adjacent to a layer Y refers to a layer that is in direct physical contact with layer Y. In contrast, as used herein, the phrase(s) "located on" (in the alternative, "located under," "located above/over," or "located next to," in the context of a first layer or component located on a second layer or component) includes (i) configurations in which the first layer or component is directly physically attached to the second layer (i.e., adjacent), and (ii) component and configurations in which the first layer or component is attached (e.g. coupled) to the second layer or component via one or more intervening layers or components.

Terms or values modified by the word "substantially" include arrangements, orientations, spacings, or positions that vary plus or minus 20% from the meaning of the unmodified term or value. Terms or values modified by the word "about" include values inclusive of 10% less than the term or value to inclusive of 10% greater than the term or value.

As used herein, the term "electronic component" can refer to an active electronic circuit (e.g., processing unit, memory, storage device, FET) or a passive electronic circuit (e.g., resistor, inductor, capacitor).

As used herein, the term "integrated circuit component" can refer to an electronic component configured on a semiconducting material to perform a function. An integrated circuit (IC) component can comprise one or more of any computing system components described or referenced herein or any other computing system component, such as a processor unit (e.g., system-on-a-chip (SoC), processor core, graphics processor unit (GPU), accelerator, chipset processor), I/O controller, memory, or network interface controller, and can comprise one or more additional active or passive devices such as capacitors, decoupling capacitors, resistors, inductors, fuses, diodes, transformers, sensors, electrostatic discharge (ESD) devices, and memory devices.

A non-limiting example of an unpackaged integrated circuit component includes a single monolithic integrated circuit die (shortened herein to "die"); the die may include solder bumps attached to contacts on the die. When present on the die, the solder bumps or other conductive contacts can enable the die to be directly attached to a printed circuit board (PCB) or other substrates.

A non-limiting example of a packaged integrated circuit component comprises one or more integrated circuit dies mounted on a package substrate with the integrated circuit dies and package substrate encapsulated in a casing material, such as a metal, plastic, glass, or ceramic. Often the casing includes an integrated heat spreader (IHS); the packaged integrated circuit component often has bumps, leads, or pins attached to the package substrate (either directly or by wires attaching the bumps, leads, or pins to the package substrate) for attaching the packaged integrated circuit component to a printed circuit board (or motherboard or base board) or another component.

The following detailed description is not intended to limit the application and use of the disclosed technologies. It may be evident that the novel embodiments can be practiced without every detail described herein. For the sake of brevity, well-known structures and devices may be shown in block diagram form to facilitate a description thereof.

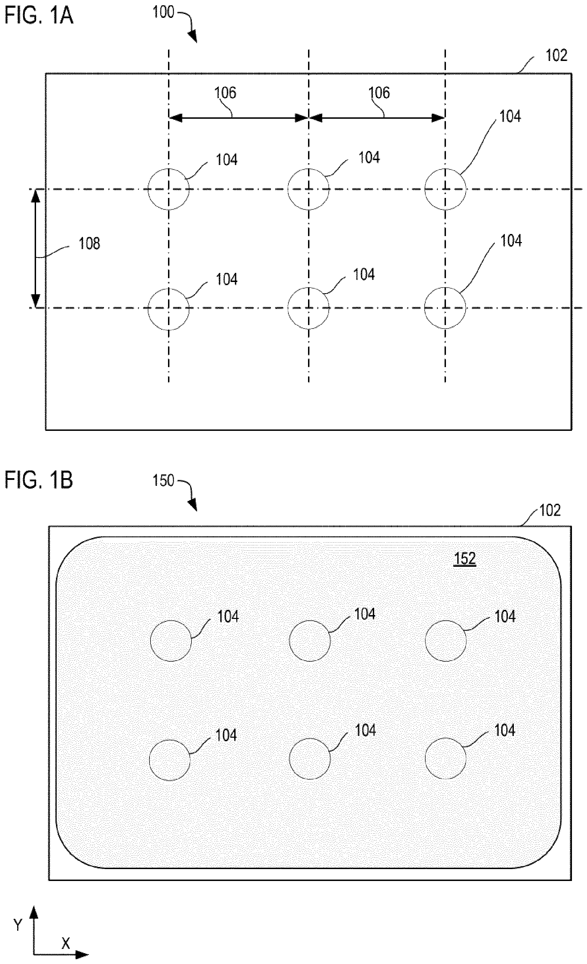

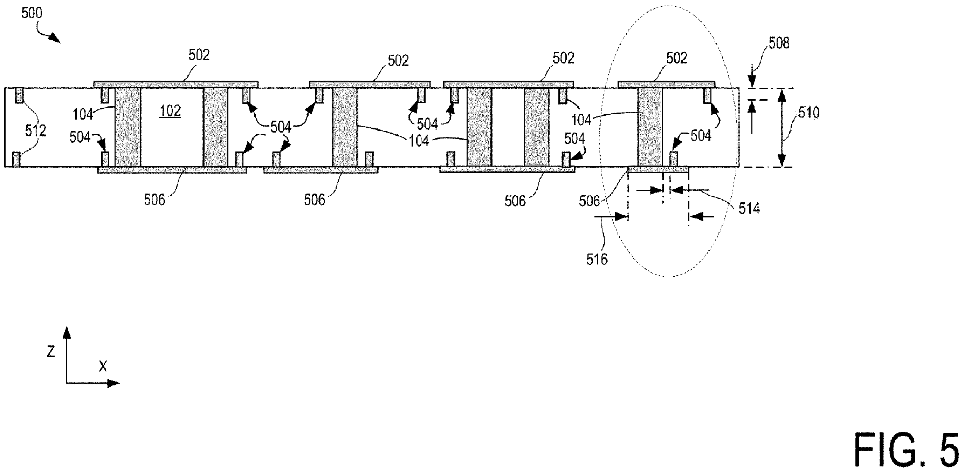

FIGS. 1A and 1B provide background for the following description of the architecture for metal lamination on a glass layer. Embodiments include a glass layer or glass core 102. The glass core 102 may comprise glass, (as used herein, glass can be an alkali-free alkaline earth boro-aluminosicilate glass, such as a glass comprising aluminum, oxygen, boron, silicon, and an alkaline-earth metal (e.g., beryllium, magnesium, calcium, strontium, barium, radium, such as a glass comprising SiO₂, Al₂O₃, B₂O₃, and MgO), or a photosensitive glass (photomachineable or photostructurable glass). In some embodiments, a photosensitive glass can be a glass that belongs to the lithium-silicate family of glass (e.g., a glass comprising lithium, silicon, and oxygen) comprising metallic particles, such as gold, silver, or other suitable metallic particles. Glass core 102 may comprise multiple glass sheets bonded together with an adhesion layer. In various embodiments, the glass core 102 may have a thickness (FIG. 5, thickness 510) in a range of about 20 microns to about 1 millimeter, +/-10%.

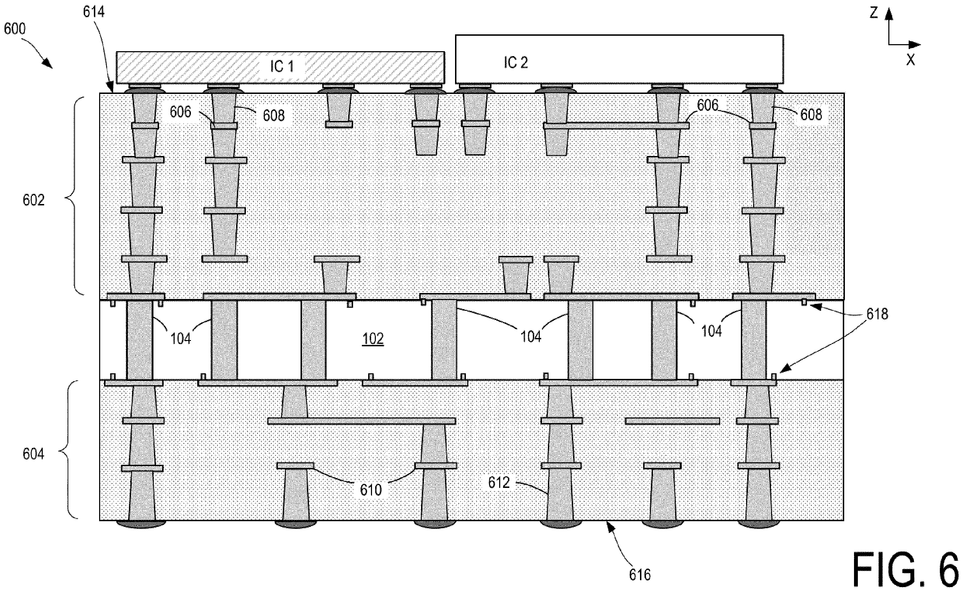

The glass core 102 may be an all-glass core. In practice, the glass "core" may be a combination of glass and epoxy. Accordingly, in various embodiments, an epoxy layer (not shown) may be located adjacent to the glass core 102 and between the glass core 102 and subsequent dielectric layers (e.g., FIG. 6, dielectric layers 602 and/or 604). The epoxy layer may include epoxy resin, a fiberglass-reinforced epoxy resin, an epoxy resin with inorganic fillers, a ceramic material, or a polymer material such as polyimide.

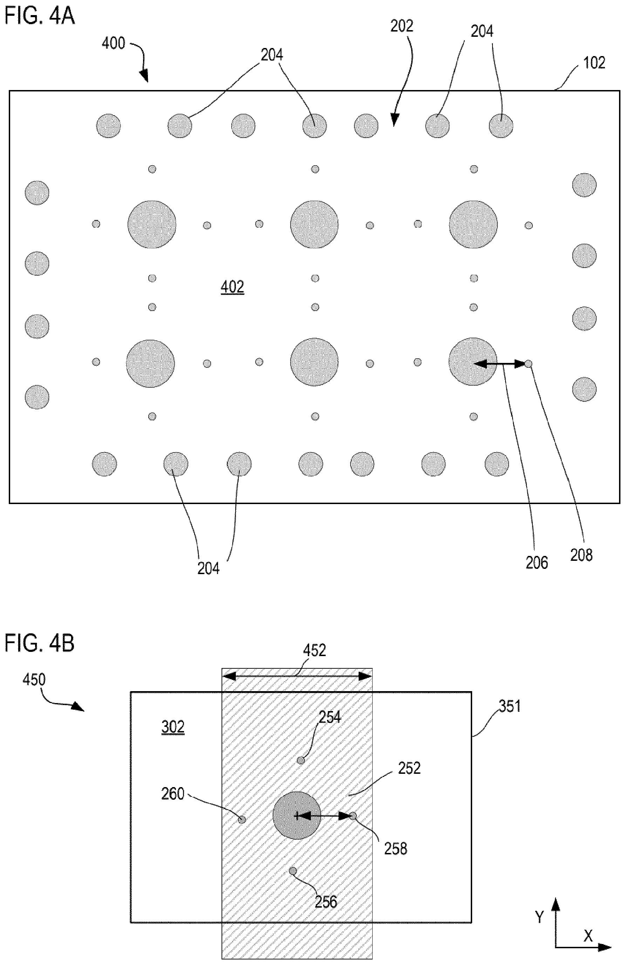

Embodiment 100 depicts a simplified pattern ("TGV pattern") showing locations for one or more through glass vias (TGVs) for a target substrate package. The pattern for the TGVs 104 may be application specific, for a target package substrate. The non-limiting example TGV pattern illustrated in FIG. 1A has the TGVs 104 arranged at a column width 106 and a column height 108. In various embodiments, the column width 106 and column height 108 can be associated with a designated pitch, and the pinout can further be referred to as a pinout. The pattern incorporates spacing to allow for the routing of signals and traces on the upper and lower surface of the glass core 102 (this concept is revisited in FIG. 4B).

In some manufacturing processes, a next processing task may be to open each of the TGVs 104 in the glass core 102 using an etch or other process; once completed, the TGVs 104 extend completely through the glass layer or glass core 102. In some manufacturing processes, a next processing task may be to fill the TGVs 104 using the metal or conductive material 152. FIG. 1B embodiment 150 shows a conductive material 152 or metal overlaid on the glass core 102. The TGVs 104, when filled, allow the glass core 102 to provide structural support while enabling electrical communication from an upper surface of the glass core 102 to a lower surface of the glass core. However, as mentioned, this process flow is vulnerable to technical problems, such as delamination of the metal (or copper) from the glass core.

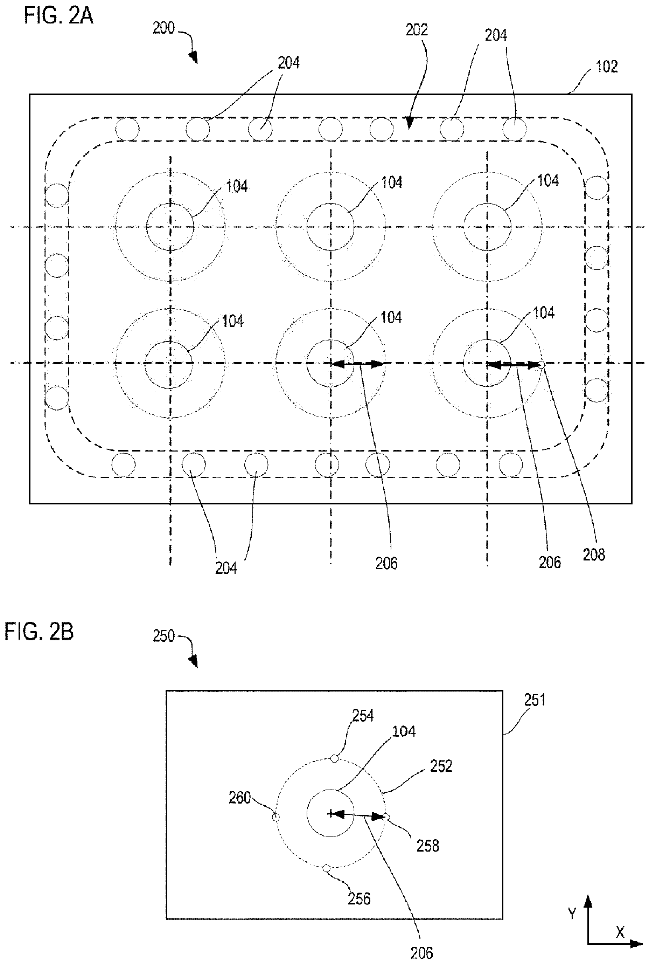

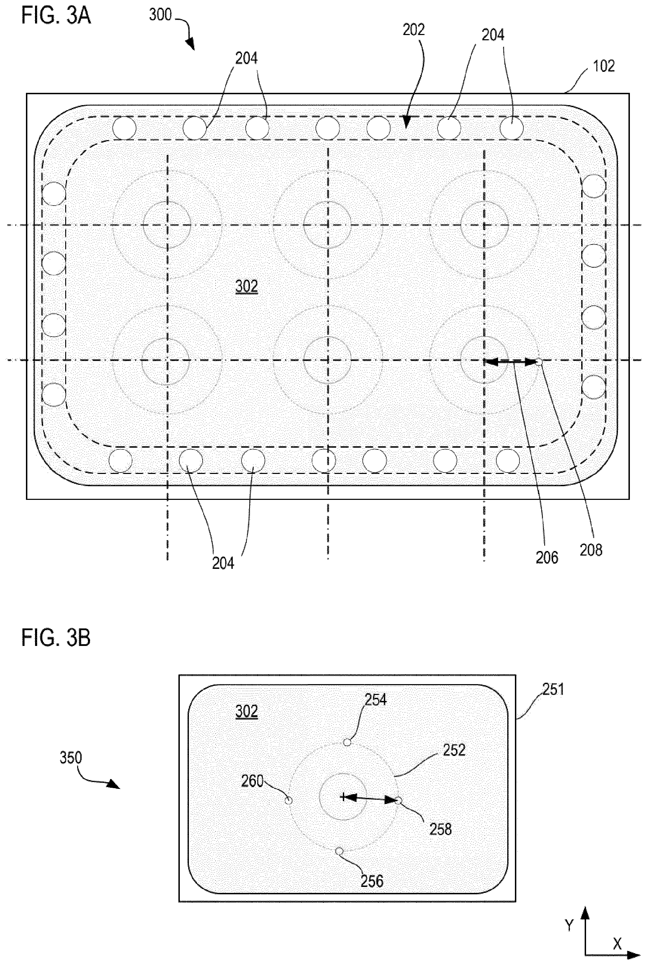

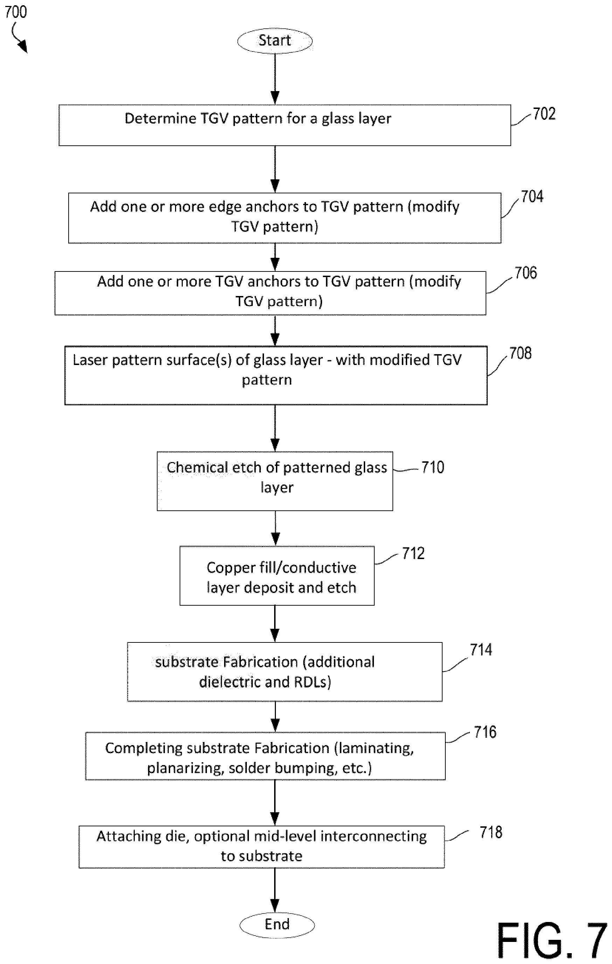

Provided embodiments modify the above manufacturing process and advantageously produce an architecture that resists delamination of the conductive material and resists cracking of the glass core. Embodiments begin with determining an intended TGV pattern (referred to herein as an "original TGV pattern") for the glass core (at 702), as described above. Embodiments of the architecture introduce anchors. The anchors may be edge anchors and/or TGV anchors; the anchors are contiguous with a conductive layer, such as copper, and hold the conductive layer in position on the glass layer. The edge anchors and TGV anchors have smaller diameters than TGVs and do not extend completely through the glass core (as distinguished from TGVs). Scanning electron microscope (SEM)/TEM images can be used to identify that the herein described anchors have been implemented in a substrate. FIGS. 2A-6 illustrate the anchor architecture in various stages of fabrication. FIG. 7 provides a process flow or method for creating the architectures and embodiments described herein.

At 704, locations for one or more edge anchors are added to the TGV pattern. Said differently, at 704, the original TGV pattern is modified to include one or more edge anchors, or at 704, a modified TGV pattern is created that includes one or more edge anchors. View 200 provides a non-limiting example of a modified TGV pattern. In view 200 a boundary path 202 is illustrated with dashed lines. The boundary path 202 circumnavigates the perimeter of the glass core 102 on the top surface. Interspersed in the boundary path 202 is a plurality of circles that can demark locations for edge anchors 204. The edge anchors have smaller diameters than the TGVs, and when fabricated, form a shallow divot but do not form a through-hole. In various embodiments, the number of edge anchors 204 can vary from substantially sparse, such as two to four, to a plurality as shown, with minimal space between subsequent edge anchors. In an example, the number of edge anchors can be based on a surface area of the glass core 102.

At 706, locations for one or more TGV anchors 208 are added to the TGV pattern. Said differently, at 704, the original TGV pattern is modified to include one or more TGV anchors 208, or at 706, a modified TGV pattern is created that includes one or more TGV anchors 208. In view 200, dashed lines encircling the TGVs 104 indicate potential locations for TGV anchors. The dashed lines depict a radius 206 from an axis of a respective TGV. The radius 206 represents a distance away from a peripheral edge of the TGV 104 that a conductive anchor 208 can be placed, but the conductive anchor 208 can be placed farther away. In various embodiments, the conductive anchor is located at least 5 microns away from the peripheral edge of the respective TGV.

One or more TGV anchors 208 can be positioned anywhere on the dashed line for respective TGVs 104. To simplify the drawing in FIG. 2A, only one TGV anchor 208 is illustrated, however those with skill in the art will appreciate that respective TGVs 104 may have one or more TGV anchors 208. View 250 in FIG. 2B provides an enlarged image of one TGV in a portion 251 of the glass core 102. TGV 104 has four TGV anchors placed around it, generally in a north, south, east, and west orientation around the axis of the TGV 104. The TGV anchors 254, 256, 258, and 260 are indicated.

Notably, embodiments may include only the modification of 704, only the modification of 706, or both modifications (704 and 706). As used herein, a "modified TGV pattern" means the original TGV pattern described above, modified at 704, 706, or 704 and 706.

Embodiments create the TGVs using a laser induced direct etch (LIDE) process. Generally, LIDE employs a laser zap that chemically changes the surface of the glass core, followed by a chemical etch that operates on the locations of the laser zap. Once the surface pattern for the glass core 102 is finalized, the LIDE process can be performed. Accordingly, at 708, the surface of the glass core 102 is laser patterned with the modified TGV pattern, and at 710, a chemical etch is performed. Subsequent to 710, embodiments include the glass core 102 with the TGVs being openings from the upper surface to the lower surface, and with some combination of openings that are divots in the glass core 102 for respective anchors. The TGVs 104 are substantially perpendicular to a bottom surface of the glass core 102. The individual TGVs 104 have a diameter of about 2 to about 150 microns.

At 712 as illustrated with view 300 and view 350, the TGVs 104 and anchors may be filled and a conductive layer 302, such as a metal (e.g., copper) may be deposited on the glass core. In practice, the conductive layer 302 may comprise traces and pads and may be referred to as a metal layer. The conductive layer 302 and filling for the TGVs 104 (and anchors) may comprise a metal (e.g., copper, aluminum, nickel, cobalt, iron, tin, gold, silver, or combinations thereof) or another suitable conductive material, and provide electrically conductive paths from an origin to a terminus of the respective trace. The conductive layer 302 may comprise a thickness in a range of about 1 micron to about 30 microns. In an embodiment, the conductive layer 302 has a thickness of about 15 microns.

In FIG. 4A, view 400 illustrates the TGVs 104, edge anchors 204, and TGV anchors 208 filled with a conductive material. As mentioned, the conductive material in the filling of the TGVs and anchors is contiguous with the conductive layer 302. FIG. 4B view 450 illustrates an example of a TGV 104 with a trace (indicated with the patterned rectangle for the purpose of distinguishing it in the figure) of width 452 overlaid on the TGV 104. In various embodiments, the trace of the conductive layer 302 indicated in FIG. 4B is representative of a trace pattern etched in the conductive layer 302 at 712.

FIG. 5 is a cross-sectional illustration of a glass core 102 patterned and filled as described above. TGVs 104, TGV anchors 504, and edge anchors 512 are shaded to convey that they are substantially filled with a conductive material, providing electrically conductive paths from an upper surface of the glass core to a lower surface of the glass core 102. The upper surface also has a conductive layer 502 that is patterned with traces. In various locations, the traces in the conductive layer 502 are contiguous and electrically conductive with the filled TGVs 104.

The lower surface may also have a conductive layer 506 that is also patterned with respective traces. In various locations at the lower surface, the traces in the conductive layer 506 are contiguous and electrically conductive with respective of the filled TGVs 104.

As mentioned above, the anchors 504 and 512, while aligned substantially parallel with the TGVs, they do not extend completely through the glass core 102; they are depicted as extending to a depth 508 that is less than the thickness 510 of the glass core 102. In various embodiments, the depth 508 is in a range of about 105 to about 40% of the thickness 510.

Enclosed in the dashed oval is an example embodiment of the architecture in a substrate. At least one substantially filled TGV 104 out of a plurality of substantially filled TGVs 104, has a conductive layer 502 (or conductive trace 502) attached to the TGV at a first surface. A width 516 of the conductive trace 502 exceeds a diameter of the TGV, such that the conductive trace 502 extends past a periphery of the TGV and it may appear as a tabletop to the TGV in the side view, as shown. At least one anchor comprising conductive material extends into the glass core 102 to a depth (referring to FIG. 5, the "depth" is depicted in the Z direction, from above or from below, as shown) from the conductive trace 502. In an example embodiment, the conductive trace 502, conductive material filling the TGV 104, and conductive material in any present anchors (504/512) all comprise copper. Under a SEM/TEM analysis, it would be observable that the anchor is located a distance 514 away from a peripheral edge of the TGV 104. In various embodiments, the minimum distance 514 is about 30% of the diameter of the TGV 104. In other embodiments, the minimum distance is about 5 to 10 microns.

The architecture and methods described in connection with FIGS. 1-5 can be implemented in substrate packages that use a glass core. For example, at 714, further substrate fabrication may be performed. FIG. 6 is a simplified illustration of a substrate package 600 with a glass core 102 that is fabricated using the architecture and methods described above. TGV anchors 618 are illustrated. In other embodiments, edge anchors 512 may be present.

Dielectric layers 602 with redistribution layers (RDL 606 and 608) therein may be added above the upper surface of the glass core 102, and/or dielectric layers 604 with redistribution layers (RDL 610 and 612) therein can be added below the lower surface of the glass core 102.

The dielectric layers 602 and 604 can include, overlaid on one or more conductive layers (e.g., RDL), a dielectric material, such as, an epoxy based organic material. In other embodiments, a suitable nitride or oxide, such as silicon dioxide (SiO₂), carbon-doped silicon dioxide (C-doped SiO₂, also known as CDO or organosilicate glass, which is a material that comprises silicon, oxygen, and carbon), fluorine-doped silicon dioxide (F-doped SiO₂, also known as fluorosilicate glass, which is a material that comprises fluorine, silicon, and oxygen), hydrogen-doped silicon dioxide (H-doped SiO₂, which is a material that comprises silicon, oxygen, and hydrogen). In some embodiments, a dielectric layer comprises a photo-imageable dielectric (PID). In some embodiments, the dielectric layer comprises an organic resin matrix with different types of fillers (for example, silica fillers of different sizes, or hollow fillers of different sizes) to control the coefficient of thermal expansion (CTE) and/or electrical properties (e.g., the dielectric constant (Dk), and/or dissipation factor (insertion loss) (Df)).

In some embodiments, it is advantageous for the dielectric layers 602 and 604 to have a CTE that matches that of target integrated circuit or PIC dies (e.g., IC 1, IC 2, and/or match the CTE of silicon) attached to a substrate or PCB. In some embodiments, the dielectric material can have a CTE that is close (e.g., within 10%) to that of silicon. In other embodiments, the dielectric material can be any type of epoxy molding compound.

The RDL layers can comprise lateral traces and vertical vias/pillars, as shown. The traces and vias/pillars 606, 608, 610, and 612 also comprise a conductive material or metal, and in various embodiments the vias 208 are substantially perpendicular to an upper surface of the dielectric layer 202.

At 716, the upper surface of the substrate or substrate package may be laminated (adding a dielectric layer generally referred to as a solder resist layer) which can be planarized to expose, on the top layer 614 and on the bottom layer 616, respective metal traces and conductive contacts. Solder material may be placed or deposited on the upper substrate surface 614 and lower substrate surface 616 for further processing.

At 718, one or more IC die may be attached to the substrate, as shown. Also, at 718, the substrate package 600 may be attached to a printed circuit board (PCB).

In various embodiments of the substrate package 600, the IC 1 die and IC 2 die can be overmolded with an encapsulant (not shown). The encapsulant can comprise a molding compound, dielectric materials, metal, ceramic, plastic, or a combination thereof. Additionally, a thermal management solution (not shown) comprising a cooling component such as a vapor chamber, heat pipe, heat sink, or liquid-cooled cold plate may be attached to a semiconductor package 600. As part of a thermal management solution, a thermal conduction layer interface material (TIM) may be located over the die. The TIM can be any suitable material, such as a silver particle-filled thermal compound, thermal grease, phase change materials, indium foils, or graphite sheets. The thermal management solution can be a conformal solution that accommodates differences in heights of the integrated circuit dies for which the thermal management solution provides cooling. For example, a thermal management solution can comprise a substantially planar cooling component with TIMs of varying thickness between the cooling component and the integrated circuit dies. In another example, the cooling component is non-planar, and the profile of the cooling component can vary with the thickness of the integrated circuit dies for which the cooling component provides cooling. In such embodiments, the TIM can be of substantially uniform thickness between the cooling component and the integrated circuit dies of varying thicknesses. Thermal management solutions can also include an integrated heat spreader.

The die IC 1 and IC 2 may be unpackaged integrated circuit die, and may alternatively be referred to as chips, chiplets, chip complexes, or chiplet complexes. While the terms die, chip, and chiplet may be used interchangeably, the term chiplet is sometimes used to refer to an integrated circuit die that implements a subset of the functionality of a larger integrated circuit component. The chiplet dimensions (lateral dimensions, as well as thicknesses) and shape can vary among chiplets; moreover, the chiplets may vary by pinout, pitch, type/functionality (e.g., compute, memory, I/O, power management (controlling the delivery of power and/or providing power to components)). Any integrated circuit die, chip, or chiplet can implement any portion of the functionality of any processor unit described or referenced herein. Furthermore, a substrate package 600 can have any shape, such as a substantially square shape, substantially rectangular shape, or substantially circular shape.

Thus, various non-limiting embodiments of architectures and methods for metal lamination on a glass layer/glass core have been provided. Embodiments implement dummy anchors (end anchors and through glass via (TGV) anchors) that prevent or reduce the delamination of the copper from glass surfaces. The anchors hold the conductive pads and conductive material planes (302) down to the surface of the glass layer and thereby prevent/reduce delamination. The following description provides additional detail and context for various die and various package assembly and device configurations that can be created based on or using the provided embodiments.

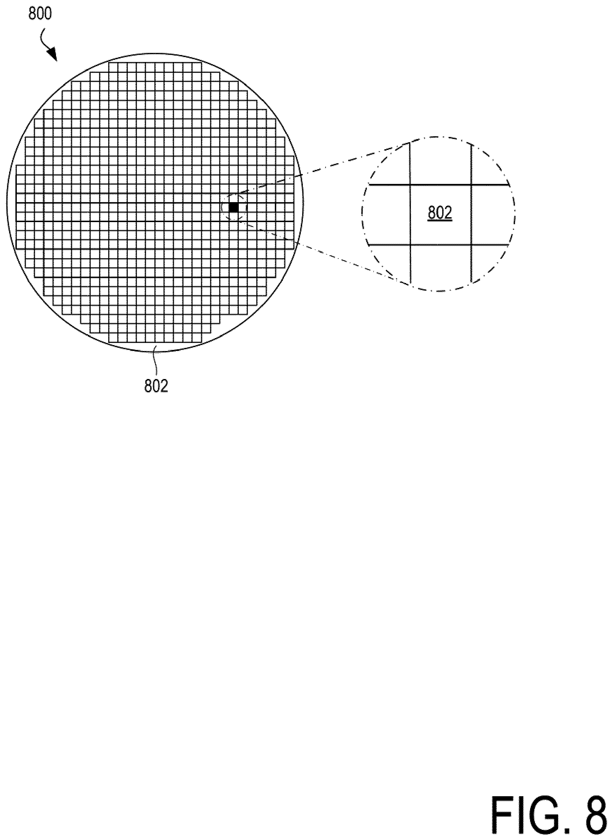

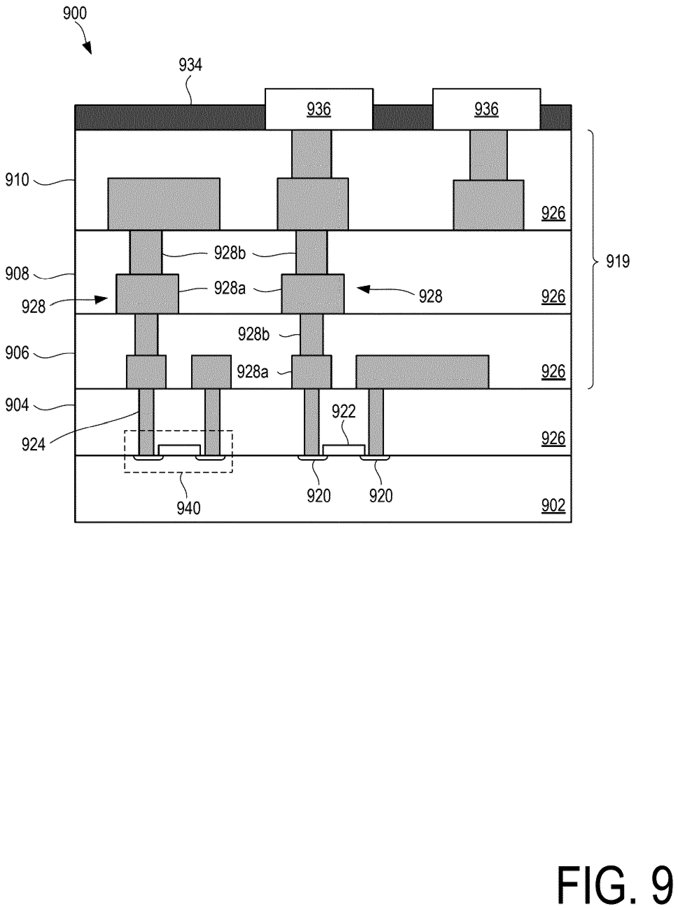

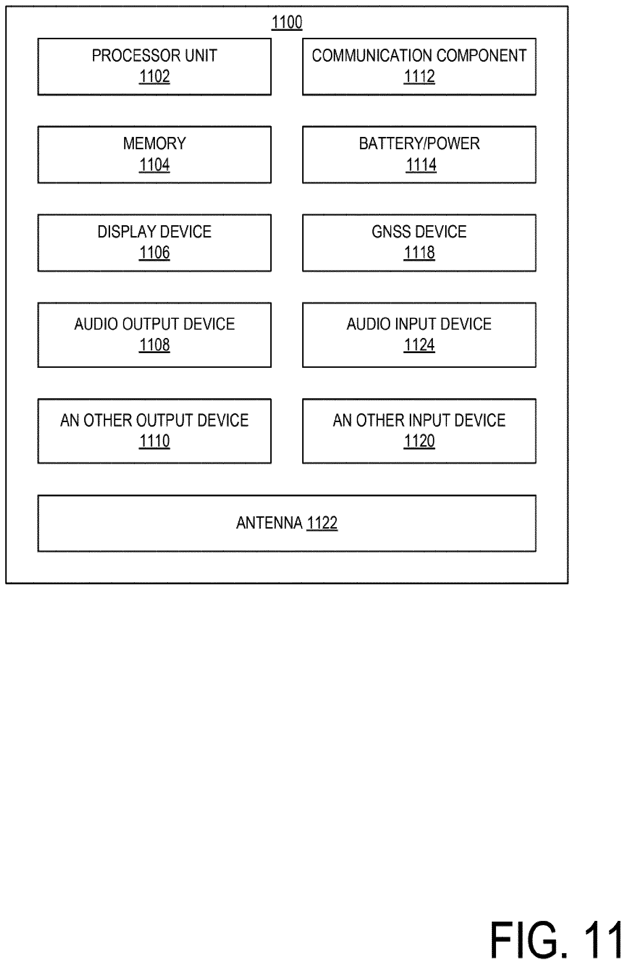

FIG. 8 is a top view of a wafer 800 and dies 802 that may be included in any of the embodiments disclosed herein. The wafer 800 may be composed of semiconductor material and may include one or more dies 802 formed on a surface of the wafer 800. After the fabrication of the integrated circuit components on the wafer 800 is complete, the wafer 800 may undergo a singulation process in which the dies 802 are separated from one another to provide discrete "chips" or destined for a packaged integrated circuit component. The individual dies 802, comprising an integrated circuit component, may include one or more transistors (e.g., some of the transistors 940 of FIG. 9, discussed below), supporting circuitry to route electrical signals to the transistors, passive components (e.g., signal traces, resistors, capacitors, or inductors), and/or any other integrated circuit components. In some embodiments, the wafer 800 or the die 802 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Additionally, multiple devices may be combined on a single die 802. For example, a memory array formed by multiple memory devices may be formed on a same die 802 as a processor unit (e.g., the processor unit 1102 of FIG. 11) or other logic that is configured to store information in the memory devices or execute instructions stored in the memory array. In some embodiments, a die 802 may be attached to a wafer 800 that includes other die, and the wafer 800 is subsequently singulated, this manufacturing procedure is referred to as a die-to-wafer assembly technique.

FIG. 9 is a cross-sectional side view of an integrated circuit 900 that may be included in any of the embodiments disclosed herein. One or more of the integrated circuits 900 may be included in one or more dies 802 (FIG. 8). The integrated circuit 900 may be formed on a die substrate 902 (e.g., the wafer 800 of FIG. 8) and may be included in a die (e.g., the die 802 of FIG. 8).

The die substrate 902 may be a semiconductor substrate composed of semiconductor material systems including, for example, n-type or p-type materials systems (or a combination of both). The die substrate 902 may include, for example, a crystalline substrate formed using a bulk silicon or a silicon-on-insulator (SOI) substructure. In some embodiments, the die substrate 902 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 902. Although a few examples of materials from which the die substrate 902 may be formed are described here, any material that may serve as a foundation for an integrated circuit 900 may be used. The die substrate 902 may be part of a singulated die (e.g., the dies 802 of FIG. 8) or a wafer (e.g., the wafer 800 of FIG. 8).

The integrated circuit 900 may include one or more device layers 904 disposed on the die substrate 902. The device layer 904 may include features of one or more transistors 940 (e.g., metal oxide semiconductor field-effect transistors (MOSFETs)) formed on the die substrate 902. The transistors 940 may include, for example, one or more source and/or drain (S/D) regions 920, a gate 922 to control current flow between the S/D regions 920, and one or more S/D contacts 924 to route electrical signals to/from the S/D regions 920.

The gate 922 may be formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be conducted on the gate dielectric to improve its quality when a high-k material is used.

The gate electrode may be formed on the gate dielectric and may include at least one p-type work function metal or n-type work function metal, depending on whether the transistor 940 is to be a p-type metal oxide semiconductor (PMOS) or an n-type metal oxide semiconductor (NMOS) transistor. In some implementations, the gate electrode may comprise a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 940 along the source-channel-drain direction, the gate electrode may comprise a U-shaped structure that includes a bottom portion substantially parallel to the surface of the die substrate 902 and two sidewall portions that are substantially perpendicular to the top surface of the die substrate 902. In other embodiments, at least one of the metal layers that form the gate electrode may simply be a planar layer that is substantially parallel to the top surface of the die substrate 902 and does not include sidewall portions substantially perpendicular to the top surface of the die substrate 902. In other embodiments, the gate electrode may comprise a combination of U-shaped structures and planar, non-U-shaped structures. For example, the gate electrode may comprise one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and include deposition and etching processes. In some embodiments, a plurality of spacer pairs may be used; for instance, two pairs, three pairs, or four pairs of sidewall spacers may be formed on opposing sides of the gate stack.

The S/D regions 920 may be formed within the die substrate 902 adjacent to the gate 922 of individual transistors 940. The S/D regions 920 may be formed using an implantation/diffusion process or an etching/deposition process, for example. In the former process, dopants such as boron, aluminum, antimony, phosphorous, or arsenic may be ion-implanted into the die substrate 902 to form the S/D regions 920. An annealing process that activates the dopants and causes them to diffuse farther into the die substrate 902 may follow the ion-implantation process. In the latter process, the die substrate 902 may first be etched to form recesses at the locations of the S/D regions 920. An epitaxial deposition process may then be conducted to fill the recesses with material that is used to fabricate the S/D regions 920. In some implementations, the S/D regions 920 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 920 may be formed using one or more alternate semiconductor materials such as germanium or a group III-V material or alloy. In further embodiments, one or more layers of metal and/or metal alloys may be used to form the S/D regions 920.

Electrical signals, such as power and/or input/output (I/O) signals, may be routed to and/or from the devices (e.g., transistors 940) of the device layer 904 through one or more interconnect layers disposed on the device layer 904 (illustrated in FIG. 9 as interconnect layers 906-910). For example, electrically conductive features of the device layer 904 (e.g., the gate 922 and the S/D contacts 924) may be electrically coupled with the interconnect structures 928 of the interconnect layers 906-910. The one or more interconnect layers 906-910 may form a metallization stack (also referred to as an "ILD stack") 919 of the integrated circuit 900.

The interconnect structures 928 may be arranged within the interconnect layers 906-910 to route electrical signals according to a wide variety of designs; in particular, the arrangement is not limited to the particular configuration of interconnect structures 928 depicted in FIG. 9. Although a particular number of interconnect layers 906-910 is depicted in FIG. 9, embodiments of the present disclosure include integrated circuits having more or fewer interconnect layers than depicted.

In some embodiments, the interconnect structures 928 may include lines 928a and/or vias 928b filled with an electrically conductive material such as a metal. The lines 928a may be arranged to route electrical signals in a direction of a plane that is substantially parallel with a surface of the die substrate 902 upon which the device layer 904 is formed. For example, the lines 928a may route electrical signals in a direction in and out of the page and/or in a direction across the page. The vias 928b may be arranged to route electrical signals in a direction of a plane that is substantially perpendicular to the surface of the die substrate 902 upon which the device layer 904 is formed. In some embodiments, the vias 928b may electrically couple lines 928a of different interconnect layers 906-910 together.

The interconnect layers 906-910 may include a dielectric material 926 disposed between the interconnect structures 928, as shown in FIG. 9. In some embodiments, dielectric material 926 disposed between the interconnect structures 928 in different ones of the interconnect layers 906-910 may have different compositions; in other embodiments, the composition of the dielectric material 926 between different interconnect layers 906-910 may be the same. The device layer 904 may include a dielectric material 926 disposed between the transistors 940 and a bottom layer of the metallization stack as well. The dielectric material 926 included in the device layer 904 may have a different composition than the dielectric material 926 included in the interconnect layers 906-910; in other embodiments, the composition of the dielectric material 926 in the device layer 904 may be the same as a dielectric material 926 included in any one of the interconnect layers 906-910.

A first interconnect layer 906 (referred to as Metal 1 or "M1") may be formed directly on the device layer 904. In some embodiments, the first interconnect layer 906 may include lines 928a and/or vias 928b, as shown. The lines 928a of the first interconnect layer 906 may be coupled with contacts (e.g., the S/D contacts 924) of the device layer 904. The vias 928b of the first interconnect layer 906 may be coupled with the lines 928a of a second interconnect layer 908.

The second interconnect layer 908 (referred to as Metal 2 or "M2") may be formed directly on the first interconnect layer 906. In some embodiments, the second interconnect layer 908 may include via 928b to couple the lines 928 of the second interconnect layer 908 with the lines 928a of a third interconnect layer 910. Although the lines 928a and the vias 928b are structurally delineated with a line within individual interconnect layers for the sake of clarity, the lines 928a and the vias 928b may be structurally and/or materially contiguous (e.g., simultaneously filled during a dual-damascene process) in some embodiments.

The third interconnect layer 910 (referred to as Metal 3 or "M3") (and additional interconnect layers, as desired) may be formed in succession on the second interconnect layer 908 according to similar techniques and configurations described in connection with the second interconnect layer 908 or the first interconnect layer 906. In some embodiments, the interconnect layers that are "higher up" in the metallization stack 919 in the integrated circuit 900 (i.e., farther away from the device layer 904) may be thicker that the interconnect layers that are lower in the metallization stack 919, with lines 928a and vias 928b in the higher interconnect layers being thicker than those in the lower interconnect layers.

The integrated circuit 900 may include a solder resist material 934 (e.g., polyimide or similar material) and one or more conductive contacts 936 formed on the interconnect layers 906-910. In FIG. 9, the conductive contacts 936 are illustrated as taking the form of bond pads. The conductive contacts 936 may be electrically coupled with the interconnect structures 928 and configured to route the electrical signals of the transistor(s) 940 to external devices. For example, solder bonds may be formed on the one or more conductive contacts 936 to mechanically and/or electrically couple an integrated circuit die including the integrated circuit 900 with another component (e.g., a printed circuit board). The integrated circuit 900 may include additional or alternate structures to route the electrical signals from the interconnect layers 906-910; for example, the conductive contacts 936 may include other analogous features (e.g., posts) that route the electrical signals to external components.

In some embodiments in which the integrated circuit 900 is a double-sided die, the integrated circuit 900 may include another metallization stack (not shown) on the opposite side of the device layer(s) 904. This metallization stack may include multiple interconnect layers as discussed above with reference to the interconnect layers 906-910, to provide electrically conductive paths (e.g., including conductive lines and vias) between the device layer(s) 904 and additional conductive contacts (not shown) on the opposite side of the integrated circuit 900 from the conductive contacts 936.

In other embodiments in which the integrated circuit 900 is a double-sided die, the integrated circuit 900 may include one or more through-silicon vias (TSVs) through the die substrate 902; these TSVs may make contact with the device layer(s) 904, and may provide electrically conductive paths between the device layer(s) 904 and additional conductive contacts (not shown) on the opposite side of the integrated circuit 900 from the conductive contacts 936. In some embodiments, TSVs extending through the substrate can be used for routing power and ground signals from conductive contacts on the opposite side of the integrated circuit 900 from the conductive contacts 936 to the transistors 940 and any other components integrated into the die 900, and the metallization stack 919 can be used to route I/O signals from the conductive contacts 936 to transistors 940 and any other components integrated into the die 900.

Multiple integrated circuits 900 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

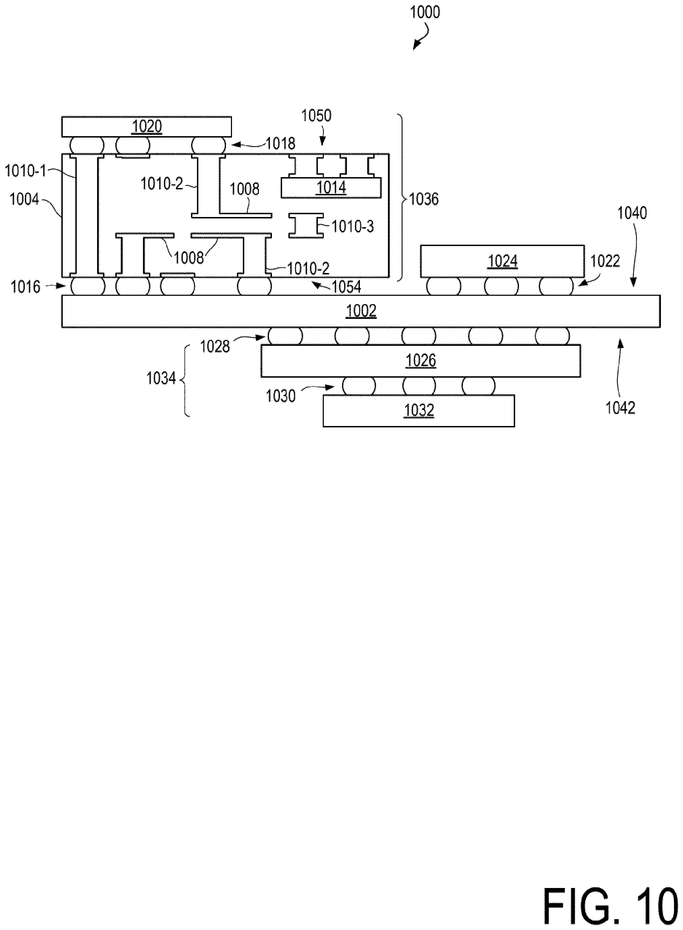

FIG. 10 is a cross-sectional side view of a microelectronic assembly 1000 that may include any of the embodiments disclosed herein. The microelectronic assembly 1000 includes multiple integrated circuit components disposed on a circuit board 1002 (which may be a motherboard, system board, mainboard, etc.). The microelectronic assembly 1000 may include components disposed on a first face 1040 of the circuit board 1002 and an opposing second face 1042 of the circuit board 1002; generally, components may be disposed on one or both faces 1040 and 1042.

In some embodiments, the circuit board 1002 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1002. In other embodiments, the circuit board 1002 may be a non-PCB substrate. The microelectronic assembly 1000 illustrated in FIG. 10 includes a package-on-interposer structure 1036 coupled to the first face 1040 of the circuit board 1002 by coupling components 1016. The coupling components 1016 may electrically and mechanically couple the package-on-interposer structure 1036 to the circuit board 1002, and may include solder balls (as shown in FIG. 10), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1036 may include an integrated circuit component 1020 coupled to an interposer 1004 by coupling components 1018. The coupling components 1018 may take any suitable form for the application, such as the forms discussed above with reference to the coupling components 1016. Although a single integrated circuit component 1020 is shown in FIG. 10, multiple integrated circuit components may be coupled to the interposer 1004; indeed, additional interposers may be coupled to the interposer 1004. The interposer 1004 may provide an intervening substrate used to bridge the circuit board 1002 and the integrated circuit component 1020.

The integrated circuit component 1020 may be a packaged or unpackaged integrated circuit component that includes one or more integrated circuit dies (e.g., the die 802 of FIG. 8, the integrated circuit 900 of FIG. 9) and/or one or more other suitable components.

The unpackaged integrated circuit component 1020 comprises solder bumps attached to contacts on the die. The solder bumps allow the die to be directly attached to the interposer 1004. In embodiments where the integrated circuit component 1020 comprises multiple integrated circuit die, the dies can be of the same type (a homogeneous multi-die integrated circuit component) or of two or more different types (a heterogeneous multi-die integrated circuit component). In addition to comprising one or more processor units, the integrated circuit component 1020 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate, or combinations thereof. A packaged multi-die integrated circuit component can be referred to as a multi-chip package (MCP) or multi-chip module (MCM).

The interposer 1004 may spread connections to a wider pitch or reroute a connection to a different connection. For example, the interposer 1004 may couple the integrated circuit component 1020 to a set of ball grid array (BGA) conductive contacts of the coupling components 1016 for coupling to the circuit board 1002. In the embodiment illustrated in FIG. 10, the integrated circuit component 1020 and the circuit board 1002 are attached to opposing sides of the interposer 1004; in other embodiments, the integrated circuit component 1020 and the circuit board 1002 may be attached to a same side of the interposer 1004. In some embodiments, three or more components may be interconnected by way of the interposer 1004.

In some embodiments, the interposer 1004 may be formed as a PCB, including multiple metal layers separated from one another by layers of dielectric material and interconnected by electrically conductive vias. In some embodiments, the interposer 1004 may be formed of an epoxy resin, a fiberglass-reinforced epoxy resin, an epoxy resin with inorganic fillers, a ceramic material, or a polymer material such as polyimide. In some embodiments, the interposer 1004 may be formed of alternate rigid or flexible materials that may include the same materials described above for use in a semiconductor substrate, such as silicon, germanium, and other group III-V and group IV materials. The interposer 1004 may include metal interconnects 1008 and vias 1010, including but not limited to through hole vias 1010-1 (that extend from a first face 1050 of the interposer 1004 to a second face 1054 of the interposer 1004), blind vias 1010-2 (that extend from the first or second faces 1050 or 1054 of the interposer 1004 to an internal metal layer), and buried vias 1010-3 (that connect internal metal layers).

In some embodiments, the interposer 1004 can comprise a silicon interposer. Through-silicon vias (TSV) extending through the silicon interposer can connect connections on a first face of a silicon interposer to an opposing second face of the silicon interposer. In some embodiments, an interposer 1004 comprising a silicon interposer can further comprise one or more routing layers to route connections on a first face of the interposer 1004 to an opposing second face of the interposer 1004.

The interposer 1004 may further include embedded devices 1014, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1004. The package-on-interposer structure 1036 may take the form of any of the package-on-interposer structures known in the art.

The integrated circuit assembly 1000 may include an integrated circuit component 1024 coupled to the first face 1040 of the circuit board 1002 by coupling components 1022. The coupling components 1022 may take the form of any of the embodiments discussed above with reference to the coupling components 1016, and the integrated circuit component 1024 may take the form of any of the embodiments discussed above with reference to the integrated circuit component 1020.

The integrated circuit assembly 1000 illustrated in FIG. 10 includes a package-on-package structure 1034 coupled to the second face 1042 of the circuit board 1002 by coupling components 1028. The package-on-package structure 1034 may include an integrated circuit component 1026 and an integrated circuit component 1032 coupled together by coupling components 1030 such that the integrated circuit component 1026 is disposed between the circuit board 1002 and the integrated circuit component 1032. The coupling components 1028 and 1030 may take the form of any of the embodiments of the coupling components 1016 discussed above, and the integrated circuit components 1026 and 1032 may take the form of any of the embodiments of the integrated circuit component 1020 discussed above. The package-on-package structure 1034 may be configured in accordance with any of the package-on-package structures known in the art.

FIG. 11 is a block diagram of an example electrical device 1100 that may include one or more of the embodiments disclosed herein. For example, any suitable ones of the components of the electrical device 1100 may include one or more of the microelectronic assemblies 1000, integrated circuit components 1020, integrated circuits 900, integrated circuit dies 802, or structures disclosed herein. A number of components are illustrated in FIG. 11 as included in the electrical device 1100, but any one or more of these components may be omitted or duplicated, as suitable for the application. In some embodiments, some or all the components included in the electrical device 1100 may be attached to one or more motherboards, mainboards, printed circuit boards, or system boards. In some embodiments, one or more of these components are fabricated onto a single system-on-a-chip (SoC) die. In various embodiments, the electrical device 3000 is enclosed by, or integrated with, a housing.

Additionally, in various embodiments, the electrical device 1100 may not include one or more of the components illustrated in FIG. 11, but the electrical device 1100 may include interface circuitry for coupling to the one or more components. For example, the electrical device 1100 may not include a display device 1106, but may include display device interface circuitry (e.g., a connector and driver circuitry) to which a display device 1106 may be coupled. In another set of examples, the electrical device 1100 may not include an audio input device 1124 or an audio output device 1108, but may include audio input or output device interface circuitry (e.g., connectors and supporting circuitry) to which an audio input device 1124 or audio output device 1108 may be coupled.

The electrical device 1100 may include one or more processor units 1102 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1102 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller crypto processors (specialized processors that execute cryptographic algorithms within hardware), server processors, controllers, or any other suitable type of processor units. As such, the processor unit can be referred to as an XPU (or xPU).

The electrical device 1100 may include a memory 1104, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1104 may include memory that is located on the same integrated circuit die as the processor unit 1102. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments, the electrical device 1100 can comprise one or more processor units 1102 that are heterogeneous or asymmetric to another processor unit 1102 in the electrical device 1100. There can be a variety of differences between the processor units 1102 in a system in terms of a spectrum of metrics of merit including architectural, microarchitectural, thermal, power consumption characteristics, and the like. These differences can effectively manifest themselves as asymmetry and heterogeneity among the processor units 1102 in the electrical device 1100.

In some embodiments, the electrical device 1100 may include a communication component 1112 (e.g., one or more communication components). For example, the communication component 1112 can manage wireless communications for the transfer of data to and from the electrical device 1100. The term "wireless" and its derivatives may be used to describe circuits, devices, systems, methods, techniques, communications channels, etc., that may communicate data using modulated electromagnetic radiation through a nonsolid medium. The term "wireless" does not imply that the associated devices do not contain any wires, although in some embodiments they might not.

The communication component 1112 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1112 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1112 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1112 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1112 may operate in accordance with other wireless protocols in other embodiments. The electrical device 1100 may include an antenna 1122 to facilitate wireless communications and/or to receive other wireless communications (such as AM or FM radio transmissions).

In some embodiments, the communication component 1112 may manage wired communications, such as electrical, optical, or any other suitable communication protocols (e.g., IEEE 802.3 Ethernet standards). As noted above, the communication component 1112 may include multiple communication components. For instance, a first communication component 1112 may be dedicated to shorter-range wireless communications such as Wi-Fi or Bluetooth, and a second communication component 1112 may be dedicated to longer-range wireless communications such as global positioning system (GPS), EDGE, GPRS, CDMA, WiMAX, LTE, EV-DO, or others. In some embodiments, a first communication component 1112 may be dedicated to wireless communications, and a second communication component 1112 may be dedicated to wired communications.

The electrical device 1100 may include battery/powercircuitry 1114. The battery/power circuitry 1114 may include one or more energy storage devices (e.g., batteries or capacitors) and/or circuitry for coupling components of the electrical device 1100 to an energy source separate from the electrical device 1100 (e.g., AC line power).

The electrical device 1100 may include a display device 1106 (or corresponding interface circuitry, as discussed above). The display device 1106 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1100 may include an audio output device 1108 (or corresponding interface circuitry, as discussed above). The audio output device 1108 may include any embedded or wired or wirelessly connected external device that generates an audible indicator, such speakers, headsets, or earbuds.

The electrical device 1100 may include an audio input device 1124 (or corresponding interface circuitry, as discussed above). The audio input device 1124 may include any embedded or wired or wirelessly connected device that generates a signal representative of a sound, such as microphones, microphone arrays, or digital instruments (e.g., instruments having a musical instrument digital interface (MIDI) output). The electrical device 1100 may include a Global Navigation Satellite System (GNSS) device 1118 (or corresponding interface circuitry, as discussed above), such as a Global Positioning System (GPS) device. The GNSS device 1118 may be in communication with a satellite-based system and may determine a geolocation of the electrical device 1100 based on information received from one or more GNSS satellites, as known in the art.

The electrical device 1100 may include another output device 1110 (or corresponding interface circuitry, as discussed above). Examples of the other output device 1110 may include an audio codec, a video codec, a printer, a wired or wireless transmitter for providing information to other devices, or an additional storage device.

The electrical device 1100 may include another input device 1120 (or corresponding interface circuitry, as discussed above). Examples of the other input device 1120 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1100 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1100 may be any other electronic device that processes data. In some embodiments, the electrical device 1100 may comprise multiple discrete physical components. Given the range of devices that the electrical device 1100 can be manifested as in various embodiments, in some embodiments, the electrical device 1100 can be referred to as a computing device or a computing system.

While at least one embodiment has been presented in the foregoing detailed description, it should be appreciated that a vast number of variations exist. It should also be appreciated that the disclosed embodiments are only examples, and are not intended to limit the scope, applicability, or configuration of the disclosure in any way. Rather, the foregoing detailed description will provide those skilled in the art with a convenient road map for implementing the disclosed embodiment embodiments. Various changes can be made in the function and arrangement of elements without departing from the scope of the disclosure as set forth in the appended claims and the legal equivalents thereof.

As used herein, phrases such as "an embodiment," "various embodiments," "some embodiments," and the like, indicate that some embodiments may have some, all, or none of the features described for other embodiments. "First," "second," "third," and the like describe a common object and indicate different instances of like objects being referred to; unless specifically stated, they do not imply a given sequence, either temporally or spatially, in ranking, or any other manner. In accordance with patent application parlance, "connected" indicates elements that are in direct physical or electrical contact with each other and "coupled" indicates elements that cooperate or interact with each other, coupled elements may or may not be in direct physical or electrical contact. Furthermore, the terms "comprising," "including," "having," and the like, are utilized synonymously to denote non-exclusive inclusions.

As used in this application and the claims, a list of items joined by the term "at least one of' or the term "one or more of' can mean any combination of the listed terms. For example, the phrase "at least one of A, B or C" can mean A; B; C; A and B; A and C; B and C; or A, B, and C. Likewise, the phrase "one or more of A, B and C" can mean A; B; C; A and B; A and C; B and C; or A, B, and C.

As used in this application and the claims, the phrase "individual of" or "respective of" following by a list of items recited or stated as having a trait, feature, etc. means that all the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

The following examples pertain to additional embodiments of technologies disclosed herein.

### EXAMPLES

Example 1 is an apparatus, comprising: a glass core comprising a plurality of through-glass vias (TGVs) substantially filled with a conductive material; a conductive trace on a surface of the glass core, the conductive trace attached to, and extending past a periphery of, a TGV of the plurality of TGVs; and a conductive anchor extending from the conductive trace into the glass core, the conductive anchor located at least a minimum distance from a peripheral edge of a TGV of the plurality of TGVs.

Example 2 includes the subject matter of Example 1, wherein the conductive material, the conductive trace, and the conductive anchor comprise a metal.

Example 3 includes the subject matter of Example 1, wherein the conductive material, the conductive trace, and the conductive anchor comprise copper.

Example 4 includes the subject matter of any one of Examples 1-3, wherein individual of the plurality of TGVs comprise a diameter, and the minimum distance is a function of the diameter.

Example 5 includes the subject matter of any one of Examples 1-3, wherein the minimum distance is about 5 to 10 microns.

Example 6 includes the subject matter of any one of Examples 1-5, wherein the conductive trace has a thickness in a range of about 1 micron to about 30 microns.

Example 7 includes the subject matter of any one of Examples 1-6, wherein the glass core comprises silicon and oxygen.

Example 8 includes the subject matter of any one of Examples 1-6, wherein the glass core comprises silicon, oxygen, and aluminum, boron, or an alkaline-earth metal.

Example 9 includes the subject matter of any one of Examples 1-8, wherein the glass core has a thickness in a range of about 20 microns to about 1 millimeter.

Example 10 includes the subject matter of any one of Examples 1-9, wherein the conductive trace is a first conductive trace on a first surface of the glass core, attached to the TGV of the plurality of TGVs at a first end, and further comprising: a second conductive trace located on a second surface of the glass core, the second conductive trace attached to a second end of the TGV of the plurality of TGVs; and a second conductive anchor extending from the second conductive trace into the glass core, the second conductive anchor located at least the minimum distance from the peripheral edge of the TGV of the plurality of TGVs.

Example 11 is a substrate package, comprising: a glass core comprising a plurality of through-glass vias (TGVs) substantially filled with a conductive material; a conductive trace on a surface of the glass core, the conductive trace attached to, and extending past a periphery of, a TGV of the plurality of TGVs; and a conductive anchor extending from the conductive trace into the glass core, the conductive anchor located a distance away from a peripheral edge of the TGV of the plurality of TGVs; one or more dielectric layers with redistribution layers therein located above the glass core and on the conductive trace; and a plurality of conductive contacts located on an upper surface of the one or more the dielectric layers.

Example 12 includes the subject matter of Example 11, wherein the conductive material, the conductive trace, and the conductive anchor comprise a metal.

Example 13 includes the subject matter of Example 11, wherein the conductive material, the conductive trace, and the conductive anchor comprise copper.

Example 14 includes the subject matter of any one of Examples 11-13, wherein individual of the plurality of TGVs comprise a diameter, and the minimum distance is a function of the diameter.

Example 15 includes the subject matter of any one of Examples 11-13, wherein the minimum distance is about 5 to 10 microns.

Example 16 includes the subject matter of any one of Examples 11-15, wherein the conductive trace has a thickness in a range of about 1 micron to about 30 microns.

Example 17 includes the subject matter of any one of Examples 11-16, wherein the glass core comprises silicon and oxygen.

Example 18 includes the subject matter of any one of Examples 11-16, wherein the glass core comprises silicon, oxygen, and aluminum, boron, or an alkaline-earth metal.

Example 19 includes the subject matter of any one of Examples 11-18, wherein the glass core has a thickness in a range of about 20 microns to about 1 millimeter.

Example 20 includes the subject matter of any one of Examples 11-19, wherein the conductive trace is a first conductive trace on a first surface of the glass core, attached to the TGV of the plurality of TGVs at a first end, and further comprising: a second conductive trace located on a second surface of the glass core, the second conductive trace attached to a second end of the TGV of the plurality of TGVs; and a second conductive anchor extending from the second conductive trace into the glass core, the second conductive anchor located at least the minimum distance from the peripheral edge of the TGV of the plurality of TGVs.

Example 21 is a method, comprising: determining a through-glass via (TGV) pattern for a plurality of TGVs in a glass core; creating a modified TGV pattern with at least one TGV anchor added thereto, the at least one TGV anchor located away from a peripheral edge of a TGV; laser patterning a surface of the glass core with the modified TGV pattern; performing a chemical etch on the surface of the glass core after completing the laser patterning the surface of the glass core; substantially filling the plurality of TGVs and the at least one TGV anchor with a conductive material; and depositing a conductive layer on the surface of the glass core, the conductive layer attached to a TGV of the plurality of TGVs and the at least one TGV anchor.

Example 22 includes the subject matter of Example 21, further comprising adding one or more dielectric layers with redistribution layers therein over the conductive layer, to thereby create a substrate.

Example 23 includes the subject matter of Example 22, further comprising planarizing an upper surface of the substrate to reveal conductive contacts.

Example 24 includes the subject matter of Example 23, further comprising depositing a solder material on the conductive contacts.

Example 25 includes the subject matter of Example 24, further comprising attaching an integrated circuit die to the substrate via the solder material.

## Claims

1. An apparatus, comprising:
a glass core comprising a plurality of through-glass vias (TGVs) substantially filled with a conductive material;
a conductive layer on a surface of the glass core, the conductive layer attached to, and extending past a periphery of, a TGV of the plurality of TGVs; and
a conductive anchor extending from the conductive layer into the glass core, the conductive anchor located away from a peripheral edge of the TGV of the plurality of TGVs.

2. The apparatus of claim 1, wherein the conductive material, the conductive layer, and the conductive anchor comprise a metal.

3. The apparatus of claim 1, wherein the conductive material, the conductive layer, and the conductive anchor comprise copper.

4. The apparatus of any one of claims 1-3, wherein individual of the plurality of TGVs comprise a diameter, a location of the conductive anchor is a function of the diameter.

5. The apparatus of claim 4, wherein the conductive anchor is located at least 5 microns away from the peripheral edge of the TGV of the plurality of TGVs.

6. The apparatus of either of claims 4 and 5, wherein the conductive layer has a thickness in a range of 1 micron +/- 10% to 30 microns +/- 10%.

7. The apparatus of any of claims 4-6, wherein the glass core comprises silicon and oxygen.

8. The apparatus of any of claims 4-6, wherein the glass core comprises silicon, oxygen, and aluminum, boron, or an alkaline-earth metal.

9. The apparatus of any of claims 4-8, wherein the glass core has a thickness in a range of 20 microns +/- 10% to 1 millimeter +/- 10%.

10. The apparatus of any of claims 4-9, wherein the conductive layer is a first conductive layer on a first surface of the glass core, attached to the TGV of the plurality of TGVs at a first end, the conductive anchor is a first conductive anchor, and further comprising:
a second conductive layer located on a second surface of the glass core, the second conductive layer attached to a second end of the TGV of the plurality of TGVs; and
a second conductive anchor, the second conductive anchor extending from the second conductive layer into the glass core, the second conductive anchor located away from a periphery of the TGV of the plurality of TGVs.

11. The apparatus of any of claims 4-10, further comprising:
one or more dielectric layers with redistribution layers therein located above the glass core and on the conductive layer; and
a plurality of conductive contacts located on an upper surface of the one or more the dielectric layers.

12. A method, comprising:
determining a through-glass via (TGV) pattern for a plurality of TGVs in a glass core;
creating a modified TGV pattern with at least one anchor added thereto, the at least one anchor located away from a peripheral edge of a TGV;
laser patterning a surface of the glass core with the modified TGV pattern;
performing a chemical etch on the surface of the glass core after completing the laser patterning the surface of the glass core;
substantially filling the plurality of TGVs and the at least one anchor with a conductive material; and
depositing a conductive layer on the surface of the glass core, the conductive layer attached to a TGV of the plurality of TGVs and the at least one anchor.

13. The method of claim 12, further comprising adding one or more dielectric layers with redistribution layers therein over the conductive layer, to thereby create a substrate.

14. The method of claim 13, further comprising planarizing an upper surface of the substrate to reveal conductive contacts.

15. The method of claim 14, further comprising depositing a solder material on the conductive contacts.
